# EUROPEAN PATENT SPECIFICATION

(11) **EP 0 862 664 B1**
(45) Date of publication and mention of the grant of the patent: **02.01.2003**
(21) Application number: 96936895.0
(22) Date of filing: 25.10.1996
(51) Int. Cl.: C23C 16/30

(54) **METHOD AND APPARATUS FOR THE DEPOSITION OF PARYLENE AF4 ONTO SEMICONDUCTOR WAFERS**
VERFAHREN UND VORRICHTUNG ZUR ABLAGERUNG VON PARYLEN AF4 AUF HALBLEITERWAFERN
PROCEDE ET APPAREIL DE DEPOT DE PARYLENE AF4 SUR TRANCHES DE SEMI-CONDUCTEURS

(30) Priority: 27.10.1995 US 549087; 27.10.1995 US 549093; 27.10.1995 US 549130; 27.10.1995 US 549133; 27.10.1995 US 549131; 27.10.1995 US 549395; 27.10.1995 US 549169; 27.10.1995 US 549635; 15.07.1996 US 679958; 15.07.1996 US 680161; 15.07.1996 US 680005; 15.07.1996 US 679956; 15.07.1996 US 679827; 15.07.1996 US 683577
(43) Date of publication of application: 09.09.1998
(73) Proprietor: SPECIALTY COATING SYSTEMS, INC., Indianapolis, Indiana 46241 (US)
(72) Inventor: BEACH, William, F., Bridgewater, NJ 08807 (US); OLSON, Roger, A., Amery, WI 54001 (US); WARY, John, Noblesville, IN 46060 (US); CRAIN, Kermit, Amery, WI 54001 (US)
(74) Representative: Jump, Timothy John Simon
(86) International application number: US9617003
(87) International publication number: WO97015699

(56) References cited:
- EP-A- 0 102 417
- EP-A- 0 434 227
- EP-A- 0 679 373
- WO-A-82/03069
- GB-A- 650 947
- US-A- 3 246 627
- US-A- 3 301 707
- US-A- 3 749 601
- US-A- 4 110 392
- US-A- 4 184 188
- US-A- 4 577 465
- US-A- 4 761 269
- US-A- 4 877 433
- US-A- 5 112 642
- US-A- 5 268 202
- US-A- 5 534 068
- JOURNAL OF APPLIED POLYMER SCIENCE, vol. 13, no. 9, 1969, pages 2325-2332, XP000612619 CHOW S W ET AL: "POLY(ALPHA,ALPHA,ALPHA',ALPHA'-TETRAFLUOR O-P-XYLYLENE)"
- DATABASE INSPEC INSTITUTE OF ELECTRICAL ENGINEERS, STEVENAGE, GB Inspec No. 4687692, YOU L ET AL: "Vapor deposition of Parylene films from precursors" XP002028353 & CHEMICAL PERSPECTIVES OF MICROELECTRONIC MATERIALS III SYMPOSIUM, CHEMICAL PERSPECTIVES OF MICROELECTRONIC MATERIALS III, BOSTON, MA, USA, 30 NOV.-3 DEC. 1992, 1993, PITTSBURGH, PA, USA, MATER. RES. SOC, USA, pages 593-598,
- PATENT ABSTRACTS OF JAPAN vol. 095, no. 005, 30 June 1995 & JP 07 050258 A (NISSIN ELECTRIC CO LTD), 21 February 1995,

## Description

### Background and Summary of the Invention

The instant invention generally relates to deposition apparatuses and methods, and more particularly to their use in preparing layers of parylene polymers.

Parylene is a general term (and registered trademark) used to describe a class of poly-p-xylylenes which are derived from a dimer having the structure: 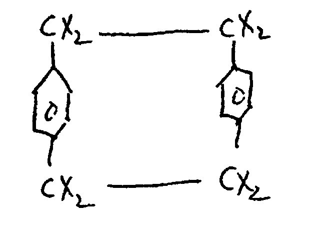 wherein X is typically a hydrogen, or a halogen. The most commonly used forms of parylene dimers include the following:

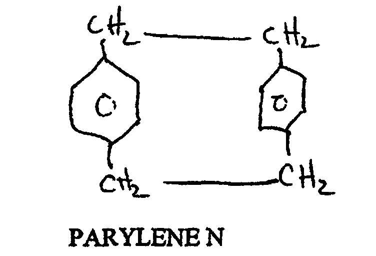

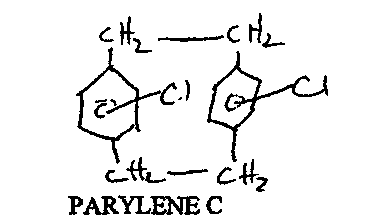

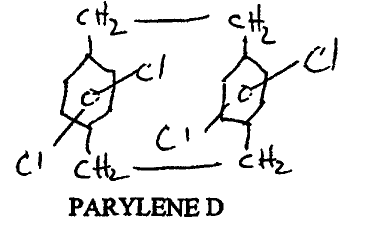

Parylene coatings are obtained from their related dimers by means of a well-known vapor deposition process in which the dimer is vaporized, pyrolized, i.e. cleaved into a monomer vapor form, and fed to a deposition chamber wherein the monomer molecules deposit and polymerize onto a substrate disposed within the deposition chamber. The process occurs according to the following reaction:

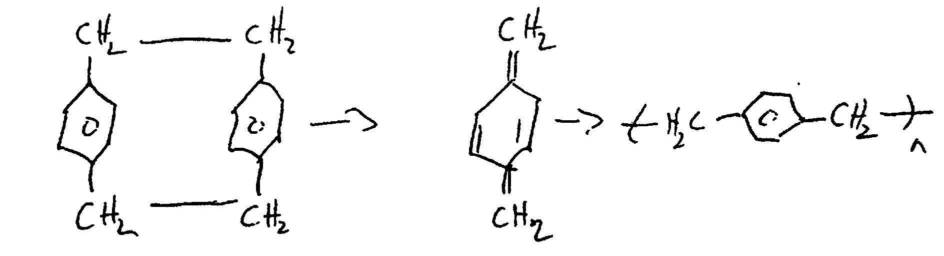

Due to their ability to provide thin films and conform to substrates of varied geometric shapes, parylene polymers are ideally suited for use as a conformal external coating in a wide variety of fields, such as for example, in the electronics, automotive, and medical industries.

Octafluoro-[2,2]paracyclophane (Parylene AF4 Dimer) is a fluorine substituted version of the above-noted parylene dimers and has the structure: 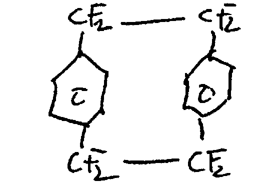 It is known that parylene coatings which are derived from the AF4 dimer by the vapor deposition process have a very high melting temperature (about 500°C) and a very low dielectric constant (about 2.3). These characteristics make Parylene AF4 ideally suited for many high temperature applications, including electronic applications, and potentially as an inter-layer dielectric material in the production of semiconductor chips. The existing parylene coating systems as used with Parylene C, D, and N, typically include a chamber system comprising a vaporization chamber, a pyrolysis chamber coupled to the vaporization chamber, and a deposition chamber coupled to the pyrolysis chamber in which the monomer vapor deposits onto a substrate and polymerizes. The existing coating systems further include a vacuum system coupled to the chambers for creating sub-atmospheric pressure conditions throughout the chamber system.

While the existing parylene deposition systems and know deposition parameters are highly effective in depositing parylene C, D, and N, there are unique process characteristics of the AF4 molecule which prevent the existing parylene coating systems from providing sufficient deposition control, uniformity of layer thickness, material efficiency, and speed of coating to be compatible with existing semiconductor chip manufacturing requirements, semiconductor chip cost structures, and semiconductor chip manufacturing time constraints. Accordingly, there is currently presented a need for a parylene deposition system particularly suited to the deposition of parylene polymers, in particular Parylene AF4, and for a method of depositing Parylene AF4 polymer onto semiconductor wafers.

The instant invention provides a parylene deposition system comprising a vaporization chamber, a pyrolysis chamber, a post-pyrolysis chamber for capturing unpyrolyzed dimer prior to entry into the deposition chamber, a deposition bell having a frusto-conical shape, a filter structure positioned at the deposition chamber inlet, a heated and cooled platen assembly for supporting a semiconductor wafer in the deposition chamber, an electrostatic clamping device for clamping the wafer in intimate thermal contact with the platen, a quartz crystal deposition rate controller, and a vacuum by-pass assembly wherein a high-conductance vacuum outlet is utilized to quickly reduce pressure in the chamber system, and a low-conductance vacuum outlet is utilized to maintain vacuum flow through the deposition chamber during the deposition procedure. The apparatus further includes an atmospheric shroud which completely envelopes the apparatus, and a source of inert gas for flooding the atmospheric shroud with an inert gas.

The vaporization chamber, pyrolysis chamber, post-pyrolysis chamber, and vacuum system, are located within a rectangular housing structure. The platen assembly is preferably located on a top surface of the housing to facilitate placement and removal of the wafers on the platen assembly. The deposition bell is received and secured over the platen assembly to form the deposition chamber.

The platen assembly comprises a thermally conductive platen, a plurality of electric heater elements for heating the platen to a predetermined temperature, and a cooling sub-assembly for cooling the platen to a predetermined temperature. Heating and cooling of a wafer disposed on the platen is accomplished by means of heat conduction through contact with the platen. The cooling sub-assembly comprises a heat exchange coil disposed in intimate thermal contact with the body portion of the platen, and further comprises a heat exchange pump effective for circulating a chilled fluid through the heat exchange coil. In operation, the chilled fluid is circulated through the heat exchange coil to lower the temperature of the wafer on the surface of the platen to a desired temperature. The heating elements are effective for quickly heating the wafer, i.e. raising the temperature of the platen back to room temperature, before removal of the wafer from the deposition chamber.

The electrostatic clamping device for electrostatically clamping the semiconductor wafer is located on the surface of the platen for maintaining the wafer in intimate thermal contact with the platen. Since the wafer temperature is controlled primarily by means of heat conduction from the platen, it is important to maintain an intimate thermal contact of the wafer with the platen surface.

In operation, the wafer is placed onto the platen and clamped in position by the electrostatic chuck which is located on the surface of the platen. The deposition bell is placed over the platen to form a deposition chamber, and thereafter, the atmospheric shroud is flooded with an inert gas to provide an inert atmosphere around the apparatus. A vacuum is then drawn through the entire system while simultaneously cooling the wafer to a desired temperature. The parylene polymer is then deposited onto the wafer according to conventional process steps, i.e. vaporization of the dimer, cleaving of the gaseous dimer into monomer form, and passing the reactive monomer over the surface of the wafer. Prior to removing the wafer from the deposition chamber, the wafer is heated back to room temperature to prevent condensation from forming on the wafer. When desired, the wafer may be further heated to a predetermined annealing temperature to anneal the parylene polymer deposited. The wafer is then cooled back to room temperature and removed from the deposition chamber.

Accordingly, among the objects of the instant invention are: the provision of a parylene deposition apparatus and method effective for the quick and efficient deposition of Parylene AF4 onto silicon wafers in the production of semiconductor chips; the provision of a parylene deposition apparatus including an atmospheric shroud enveloping the apparatus, and a source of inert gas for flooding the shroud during pump down and the actual deposition process; the provision of a parylene deposition apparatus including a heated and cooled platen for supporting the wafer in the deposition chamber and for controlling the temperature of the wafer during deposition procedures; and the further provision of a method for fast, efficient, and cost effective deposition of Parylene AF4 onto the surface of the silicone wafer.

According to a first aspect of the present invention, there is provided a parylene deposition apparatus comprising: a vaporization chamber; a pyrolysis chamber in fluid communication with said vaporization chamber; a deposition chamber in fluid communication with said pyrolysis chamber; a thermally conductive platen disposed in said deposition chamber for supporting an article to be coated; a device for reducing the temperature of the thermally conductive platen such that the article disposed thereon may be cooled to a temperature below 15°C; and the apparatus further comprising a heater for heating the thermally conductive platen to a temperature of from 100°C to 400°C prior to the removal of the article from the deposition chamber.

According to a second aspect of the invention, a parylene deposition chamber is provided, comprising: a body including an inlet opening having a diameter and at least one outlet opening having a diameter, the diameter of the inlet opening being greater than the diameter of the at least one outlet opening; an inlet pipe in fluid communication with the inlet opening; an outlet pipe in fluid communication with the at least one outlet opening; a valve disposed at a junction between the inlet pipe and the outlet pipe; a thermally conductive platen for supporting an article to be coated; a device for reducing the temperature of the thermally conductive platen such that the article disposed thereon may be cooled to a temperature below 15°C; and further comprising a heater for heating the thermally conductive platen to a temperature of from 100°C to 400°C prior to the removal of the article from the deposition chamber.

According to a third aspect of the present invention, there is provided a vacuum chamber system comprising: a vaporization chamber having an outlet; a pyrolysis chamber having an inlet and an outlet, the inlet of the pyrolysis chamber being in fluid communication with the outlet of the vaporization chamber; and a parylene deposition chamber comprising: a body including an inlet opening having a diameter and at least one outlet opening having a diameter, the diameter of the inlet opening being greater than the diameter of the at least one outlet opening, the inlet opening being in fluid communication with the outlet of the pyrolysis chamber; an inlet pipe in fluid communication with the inlet opening; an outlet pipe in fluid communication with the outlet opening; a valve disposed at the junction of the inlet pipe and the outlet pipe; a thermally conductive platen disposed in the deposition chamber for supporting an article to be coated; a device for reducing the temperature of the thermally conductive platen such that the article disposed thereon may be cooled to a temperature below 15°C; and further comprising a heater for heating the thermally conductive platen to a temperature of from 100°C to 400°C prior to the removal of the article from the deposition chamber.

According to a fourth aspect of the present invention there is provided a method of forming a layer of parylene on a substrate in a deposition chamber, the method comprising the steps of: vaporising parylene dimer; pyrolyzing the parylene dimer to form parylene monomers; cooling the substrate to a temperature below 15°C; depositing parylene monomers on the substrate; and heating the substrate to a temperature of from 100°C to 400°C prior to its removal from the deposition chamber.

Other objects, features and advantages of the invention shall become apparent as the description thereof proceeds.

### Description of the Preferred Embodiment

There follows a non-limiting example of one possible embodiment of the invention. As will hereinafter be more fully described, the instant parylene deposition apparatus is effective for the quick and efficient deposition of Parylene AF4 material onto the surface of a silicon wafer.

The parylene deposition apparatus generally comprises a platen assembly for supporting a semiconductor wafer, a vaporization chamber, a pyrolysis chamber, a post-pyrolysis chamber; a deposition bell, a vacuum pump, and a cold trap. The vaporization chamber, pyrolysis chamber, post-pyrolysis chamber, vacuum pump, and cold trap are located within a rectangular housing structure.

The apparatus further comprises an atmospheric shroud which completely envelopes the entire apparatus, and a source of nitrogen gas which is introduced into the shroud by a suitable pipe assembly.

The platen assembly is preferably located on a top wall of the housing to facilitate placement and removal of the wafers on the platen assembly. The deposition bell is received and secured over the platen assembly to form a deposition chamber. The deposition bell and its associated inlet and outlet pipes, are preferably formed as a single removable unit, and are arranged so as to provide a mating engagement of the deposition bell with the top of the platen assembly and a mating engagement of the inlet and outlet pipes, with corresponding fittings on the top wall of the housing. The removable deposition bell further facilitates access to the platen assembly for the placement and removal of wafers.

The platen assembly comprises a thermally conductive platen having a supporting surface for supporting a wafer to be coated, a plurality of electric heater elements for heating the platen to a predetermined temperature, and a cooling sub-assembly for cooling the platen to a predetermined temperature. It has been found that Parylene AF4 vapor condenses or polymerizes most effectively on surfaces which have been chilled to a temperature below room temperature, more preferably below about 0°C, even more preferably below about -45 °C and most preferably below about -80°C. The platen of the instant invention provides an effective surface for supporting a semiconductor wafer within the deposition bell, and further provides an effective means for heating and cooling the wafer to desired temperatures during the coating process. More specifically, the heating and cooling of a wafer is accomplished by means of heat conduction through contact with the platen. The platen is preferably constructed from a metallic material which has very good thermal conduction characteristics. In this regard, brass and copper are suitable metallic materials for construction of the platen. The heating elements for heating the platen comprise electric cartridge heating elements which are inserted into radially extending openings formed in a body portion of the platen. The cooling sub-assembly comprises a heat exchange coil disposed in intimate thermal contact with the body portion of the platen, and further comprises a heat exchange pump effective for circulating a chilled fluid through the heat exchange coil. The specifics of heat exchange coil construction and heat exchange pumps are well known in the heat transfer arts, and therefore, they will not be described further herein. In operation, the chilled fluid is circulated through the heat exchange coil to lower the temperature of the wafer on the surface of the platen to a desired temperature. Once the wafer is at the desired temperature, the deposition process can proceed. However, since the wafer is now chilled, i.e. cooler than room temperature, the wafer cannot thereafter be immediately removed from the deposition chamber because moisture from the air will condense on the chilled wafer. In this connection, the heating elements are effective for quickly heating the wafer, i.e. raising the temperature of the platen back to room temperature, before removal of the wafer from the deposition chamber. This procedure will effectively eliminate any chances of condensation forming on the wafers. It is also contemplated that the heating elements may be effective for further raising the temperature of the wafer up to a temperature above about room temperature, more preferably above about 100°C and most preferably from about 100°C to about 470°C for purposes of annealing the Parylene coating after deposition.

The. platen assembly further comprises an electrostatic clamping device for electrostatically clamping the semiconductor wafer in intimate thermal contact with the platen surface. Since the wafer temperature is controlled primarily by means of heat conduction from the platen, it is important to maintain an intimate thermal contact of the wafer with the platen surface. The electrostatic clamping device provides an extremely simple way of maintaining an intimate thermal contact without cumbersome mechanical clamping devices. The electrostatic clamping device is located on the surface of the platen, and comprises an inter-digital printed circuit capacitor sandwiched between two layers of a thermally conductive, dielectric material.

The circuit capacitor is energized by a conventional electric source having insulated leads which pass through the platen and connect to the capacitor,

The specific details of a representative-type electrostatic clamping device are described in U.S. Patent No. 4,184,188.

The vaporization chamber comprises a cylindrical housing having an inlet end and an outlet end . The inlet end of the housing is provided with a hinged door which is attached to a flange of the housing . The hinged door is movable between open and closed positions to permit selective access to the interior of the housing for the placement of Parylene AF4 dimer into the vaporization chamber. In order to maintain a vacuum seal at the door opening, the door is provided with an elastomeric gasket . Located inside the vaporization chamber is a dimer heating device which is effective for vaporization of the dimer.

The powdered AF4 dimer is received in a removable dimer crucible, which is in turn received into a heat transfer receptacle. Alternatively, the dimer. may be received directly into the receptacle. The dimer crucible and receptacle are preferably fashioned from a thermally conductive metal, and the dimer crucible is preferably dimensioned so as to fit into the receptacle in intimate thermal contact with the receptacle such that heat from the receptacle is readily conducted to the dimer crucible through contact. The heat transfer receptacle is preferably heated by a plurality of electric heating elements disposed around the receptacle in intimate thermal contact with the receptacle. The electric heating elements comprise a nichrome wire construction, suitably insulated. and wrapped around the receptacle. The electric heating elements are operative for quickly heating the receptacle to a temperature which is suitable for the vaporisation of the dimer, which temperature is between about 70°C and about 100°C. It can therefore be seen that the dimer heating device of the instant invention provides for quick and efficient heating of the dimer to the required vaporization temperature.

The dimer heating device further includes a cooling assembly for quickly cooling the heat transfer receptacle to a temperature below the vaporization temperature of the dimer. The cooling assembly comprises a heat exchange coil disposed in intimate thermal contact with the heat transfer receptacle and a heat exchange pump for circulating a cooler fluid through the heat exchange coil. The specifics of heat exchange coil construction and heat exchange pumps are well known in the heat transfer arts, and therefore, they will not be described further herein. In order to effectively control rates of deposition of the Parylene AF4 onto the wafer, it is necessary to control the rate of vaporization of the dimer into the deposition system. In this connection, the cooling assembly can be utilized to quickly cool the dimer to quench vaporization, i.e. reduce the rate of vaporization. Ideally, the circulating fluid would be maintained at a temperature only slightly below the vaporization temperature, such that temperature of the heat transfer receptacle would only drop to a point effective to stop vaporization. The resulting temperature drop may only be that of several degrees. Accordingly, it can be seen that the heating and cooling mechanisms permit the temperature of the heat transfer receptacle to be quickly cycled above and below the vaporization temperature to effectively control the rate of vaporization of the dimer.

The outlet end of the vaporization chamber is coupled to an inlet opening of the pyrolysis chamber by a pipe. The pipe extending between the vaporization chamber and the pyrolysis chamber preferably includes a throttle valve for controlling the flow of vaporized dimer into the pyrolysis chamber. In coating operations, it has been found effective to utilize a throttle valve to immediately stop the flow of vaporized dimer into the pyrolysis chamber to stop the deposition process. In use, when it is desired to stop the coating process, i.e. when a desired coating thickness has been achieved, the throttle valve is closed to prevent any further vapor flow through the system. The coated article can then be removed from the deposition chamber and replaced with another article to be coated. In this connection, when the throttle valve is closed to stop flow, it is desirable to stop further vaporization of the dimer within the vaporization chamber as further vaporization will increase pressure within the vaporization chamber and cause a rush of vapor into the system when the throttle valve is reopened. Accordingly, the cooling assembly would be employed to quickly cool the dimer and quench vaporization.

The pyrolysis chamber receives the vaporized dimer from the vaporization chamber, and is effective for super-heating the vaporized dimer to a predetermined pyrolysis temperature wherein the dimer is cleaved into monomer form. The construction of pyrolysis chamber is conventional in the art comprising a tube, the walls of which are heated by an electric tube heater. The tube heater is preferably effective for maintaining the pyrolysis chamber at a temperature of about between about 650°C and about 720°C, and more preferably at a temperature of about 690°C.

The outlet of the pyrolysis chamber is coupled to an inlet of the post-pyrolysis chamber. The post-pyrolysis chamber comprises a cylindrical housing having a plurality of baffle elements disposed in the interior thereof. The monomer exiting from the pyrolysis chamber passes through the post-pyrolysis chamber on its way to the deposition chamber, , wherein the post-pyrolysis chamber is effective for capturing any unpyrolyzed dimer that may pass through the pyrolysis chamber. More specifically, the post-pyrolysis chamber is maintained at a temperature of between about 22°C and about 28°C, and more preferably at a temperature of about 25°C (about room temperature). The post-pyrolysis chamber is maintained at its desired temperature by means of an external fan. With regard to capturing of the unpyrolyzed dimer, it has been found that the unpyrolyzed dimer, being twice as heavy as the reactive monomer, preferentially condenses, or deposits, in the post-pyrolysis chamber when the post-pyrolysis chamber is maintained at the indicated temperatures. Removal of the unpyrolyzed dimer before deposition is important in the coating of semiconductor wafers, as the unpyrolyzed dimer constitutes an impurity in the polymer chain which may locally effect dielectric constant and polymer surface characteristics.

The outlet of the post-pyrolysis chamber terminates in a fitting located on the top wall of the housing, and is coupled to the inlet pipe of the deposition bell. In this regard, the inlet pipe includes a complimentary fitting which is received in mating engagement with the post-pyrolysis outlet fitting when the deposition bell is received onto the plate. The fittings are provided with an elastomeric gasket to provide a vacuum tight engagement

The deposition bell is frusto-conical in shape having a smaller diameter inlet end and a larger diameter outlet end. The outlet end of the deposition bell is defined by a rim which is received in mating engagement with the supporting surface of the platen to define a frusto-conical shaped deposition chamber. The particular shape of the deposition bell minimizes deposition chamber volume and maximizes vapor flow over the surface of the wafer supported on the platen adjacent to the outlet end of the chamber. While the bell is said to be frusto-conical, it is to be understood that virtually any tapered arrangement of the bell, such as a pyramidal shape, would provide the desired minimization of volume and, and maximization of vapor flow. The deposition bell further includes a filter assembly disposed adjacent to the inlet end thereof for filtering out impurities in the vapor. The filter assembly is positioned in the interior of the bell and comprises a filter element captured between two opposing annular rings, secured to the interior wall of the bell with appropriate removable fasteners. such as screws. The filter element preferably comprises a microscopic filter material, such as PTFE, which permits sufficient gas flow and which is capable of filtering substantially all airborne impurities having a size larger than 0.1 micrometer. It is noted that the lower ring is easily removable for periodic replacement of the filter element.

In order to draw a vacuum flow through the deposition bell from the inlet end to the outlet end, the vacuum pump is coupled to a plurality of outlet openings in the rim by means of a distribution manifold. The distribution manifold comprises and annular channel which is secured to the outer surface of the rim. The outlet openings communicate with an interior channel of the manifold. A first, smaller diameter, outlet pipe is connected to the manifold in a predetermined location, and the plurality of outlet openings are distributed around the periphery of the rim in a distribution pattern intended to equalize the vacuum flow throughout the chamber.

There may be more outlet openings further away from the connection point of the outlet pipe than adjacent to the outlet pipe. In other words, the cross-sectional flow area are the openings increases further and further away from the vacuum source.

While the described vacuum flow/manifold arrangement is ideal for drawing a uniform vapor flow over the surface of the wafer during the deposition process, i.e. maintaining an operating vacuum pressure within the chamber system, the cross-sectional flow area of the first outlet pipe is not sufficient to provide a quick evacuation of the chamber system down to the operating pressure. In other words, a significant amount of time is required to pump down the chamber system to the operating pressure utilizing the first outlet pipe by itself. Accordingly, in order to reduce the vacuum cycle time, the deposition bell is provided with a vacuum by-pass arrangement. In this regard, the inlet of the deposition bell is connected to a second, larger diameter outlet pipe, which is provided with a by-pass valve adjacent the deposition bell inlet. The first smaller diameter outlet pipe merges with the second larger diameter outlet pipe at a fitting, and the second outlet pipe is coupled to the vacuum pump. More specifically, the second outlet pipe terminates in an outlet pipe fitting which engages with a vacuum fitting on the top wall of the housing. A housing fitting is coupled to the vacuum pump by another pipe section. The outlet pipe fitting is received in mating engagement with housing fitting when the deposition bell is received on the platen. The outlet pipe and housing fittings are provided with an elastomeric gasket to maintain a vacuum tight engagement. In operation, the by-pass valve would remain open, wherein initial pump-down of the chamber system would be accomplished through both the first and second outlet pipes.

As soon as a desired operating pressure is achieved, the by-pass valve is closed, and the desired pressure is maintained solely by the first outlet pipe connected to the distribution manifold .

A pipe section is coupled to the inlet of the vacuum pump, and is preferably provided with a valve for selectively providing a vacuum to the chamber system. The valve is located downstream of the housing fitting so that the deposition bell assembly can be removed from the top of the housing when the valve is closed. The vacuum pump comprises an oil free, or dry, vacuum pump, such as DRYTEL SERIES dry pump manufactured by ALCATEL, Inc. The outlet of the vacuum pump is coupled to an inlet of the cold trap which comprises a cylindrical tube having an open top. The tube is mounted to the top wall of the housing and includes a fitting at the open top thereof. A cylindrical finger element having a complementary flange at the top thereof is slidably received into the tube with the fittings engaging at the top. The fittings are provided with an elastomeric gasket for a vacuum tight engagement. The finger element is preferably cooled by means of liquid nitrogen received in a cylindrical opening in the top of the finger element. The outlet of the cold trap opens to ambient atmosphere by means of a pipe. In operation, any free monomer which did not deposit in the deposition chamber deposits onto the surface of the cold finger disposed in the cold trap chamber.

The use of an oil-free, dry pump is significant in terms of its use with a Parylene AF4 deposition apparatus. The prior art parylene deposition device typically utilized a cold trap directly connected to the deposition chamber outlet, and a conventional vacuum pump downstream of the cold trap. The primary purpose of placing the cold trap between the deposition chamber and the vacuum pump was to trap any excess monomer and prevent the monomer from flowing through the pump where it could deposit internally and interfere with operation of the pump and/or contaminate the oil. The prior Parylene materials (Parylene C, D, and N) effectively deposited onto surfaces having a temperature of about 15 - 40°C which just happens to be the normal operating temperatures of such pumps. The cold trap was further effective for preventing back-streaming of oil vapors into the deposition chamber. Hence, the cold trap was necessary to trap excess monomer from depositing onto the internal surfaces of the vacuum pump, and prevent oil vapor from back-streaming into the deposition chamber.

However, placement of the cold trap in direct communication with the deposition chamber is known to cause at least one drawback. It has been found that the cold trap creates a cryo-pumping arrangement which has been shown to rapidly draw monomer through the system faster than the background atmosphere is pumped by the vacuum pump. The result is that the monomer is drawn very quickly through the deposition chamber, and is not allowed sufficient time to polymerize. The problem has been compensated for by utilizing excess dimer, and increasing coating cycle time. This was not previously found to be that significant a drawback in that the cost of Parylene C, D, and N is not prohibitive.

It has been found that the newer parylene AF4 will not deposit onto heated substrates in the range of 15-40°C, and thus the prior problem of pump deposition is eliminated. However, the use of an oil pump still leaves the problem of oil vapor back-streaming into the deposition chamber. Since one of the intended uses of the apparatus is in the coating of highly sensitive semiconductor wafers, the presence of any foreign vapors is not desired. The instant arrangement of an oil-free vacuum pump effectively eliminates the need for an upstream cold trap, and eliminates the stated drawbacks of the prior art devices. Furthermore, since the vacuum pump is connected directly to the deposition chamber outlet, both the background gasses and the monomer vapor are drawn at an equal rate through the deposition chamber, thus reducing the amount of dimer needed to effectuate the desired coating thickness. This is highly significant when considered in conjunction with the high cost of Parylene AF4 dimer, and the desire the reduce the quantity utilized for each deposition cycle.

The parylene deposition apparatus further comprises an electronic controller operative for electronically controlling all aspects of the deposition process, including temperature, and pressure regulation. The controller comprises a conventional microprocessor device which is programmed according to conventional programming techniques well known in the electronics arts. With regard to temperature regulation, the heating and cooling devices of the vaporization chamber, pyrolysis chamber, post-pyrolysis chamber and platen assembly are each connected to the controller by appropriate electrical connections. Furthermore, the vaporization chamber, pyrolysis chamber, post-pyrolysis chamber, and platen assembly are each provided thermocouples, or other appropriate device for measuring temperature. The thermocouples are connected to the controller by appropriate electrical connections wherein the desired temperatures of the various chambers are monitored by various set point comparators, and wherein the heating and cooling devices are controlled by the controller responsive to the measured temperatures to maintain the desired set point temperatures. With regard to pressure regulation, the vacuum pump and associated valves are connected to the controller for automated control of the vacuum system. The deposition bell is provided with a thermistor gauge for measuring pressure within the deposition chamber, and the thermistor gage is connected to the controller wherein the vacuum pump and vacuum pump valves are controlled responsive to measured pressure. Furthermore, the throttle valve adjacent the vaporization chamber is also connected to the controller for automated control of the valve, and the electrostatic clamping device is connected to the controller for automated control of the clamping device.

The instant parylene deposition apparatus still further includes a quartz-crystal thickness/vaporization rate control system including a quartz crystal assembly disposed within the deposition chamber. More specifically, the quartz crystal assembly is disposed within a recess located on the peripheral edge of the platen. The crystal assembly includes a disc-shaped crystal and two electrical leads mounted to opposing sides of the crystal. In operation. the parylene monomer vapor deposits onto the surface of the crystal varying the vibration frequency of the crystal.

The rate of change in frequency can be directly correlated with rate of deposition of the parylene monomer onto the crystal, and thus onto the substrate to be coated. The crystal is electrically connected to an oscillator for measuring the frequency of the crystal which varies with the thickness of the coating on the crystal. The oscillator is connected to the micro-controller which measures the frequency changes of the crystal and continuously calculates the rate of deposition of the parylene monomer vapor. Furthermore, the microprocessor is connected to a set point comparator which compares the calculated deposition rate to a set or desired deposition rate. The microprocessor then operates to increase or decrease the temperature of the vaporization chamber, or to open or close the throttle valve to provide more or less parylene dimer to the system. In other words, the controller monitors the changes in frequency of the crystal as parylene is deposited onto the crystal, and adjusts the amount of parylene dimer released into the system by adjusting the temperature of the vaporization chamber, and controlling the throttle valve. The oscillator and set point comparator are well known items in the electronics arts, and therefore they will not be described further.

A primary consideration in development of the instant apparatus is the extremely high cost of Parylene AF4 materials. In order to make Parylene AF4 coatings cost efficient, it is important that deposition efficiency be relatively high. Since Parylene AF4 has an affinity to deposit on only cool substrates, it is desirable to heat the internal walls of several areas of the apparatus to prevent the dimer and monomer from depositing onto the internal walls of the apparatus. More specifically, the internal walls of the vaporization chamber are provided with independent heating elements to prevent the vaporized dimer from depositing onto the walls of the chamber after vaporization. Furthermore, the door of the vaporization chamber is provided with a heating element to prevent deposition onto the inside surface of the door . The walls of the deposition bell are also provided with heating elements to prevent the monomer from depositing onto the internal walls of the deposition chamber. In this connection, the walls of the deposition bell should be heated to a temperature of between about 30 and about 50°C to effectively prevent deposition. Still further, the by-pass valve adjacent the inlet of the deposition bell is provided with a heating element to prevent the monomer from depositing onto the valve surface before reaching the deposition chamber.

As described hereinabove, the entire apparatus is enveloped in an atmospheric shroud, and provided with an inert nitrogen atmosphere. The purpose of the shroud and nitrogen atmosphere is to exclude oxygen from the deposition chamber during evacuation and subsequent coating cycle, thus allowing the coating process to be carried out in an oxygen free environment. Currently, the prior art parylene coating devices operate in normal amiospheric conditions. This allows for oxygen to be present as a constituent background gas, and as a constituent of any atmospheric leakage into the chamber during the coating cycle. It has been found that oxygen can chemically combine with the Parylene reactive monomer in the pyrolysis and post pyrolysis zones, and thereby cause weak polymer bonds. Accordingly, the shroud is effective to isolate the apparatus in an inert nitrogen atmosphere before pump down, and during the coating cycle. Preliminary test results have shown that the inert atmosphere provides a purer, denser and more stable coating. While nitrogen is specifically described herein as the preferred atmospheric element, it is to be understood that other inert gases, such as argon, are also suitable for the intended purpose.

A representative use of the apparatus will be described by way of the following example wherein an 200 mm (8 inch) silicon wafer will be coated with a 1 micrometer layer of Parylene AF4. With the vacuum control valve closed, the deposition bell assembly is removed and the wafer placed in the center of the platen. The electrostatic clamp is activated to hold the wafer in position, and the deposition bell is replaced. Prior to evacuation of the chambers, about 1 gram of Parylene AF4 dimer is placed into the dimer crucible, and the crucible placed in the heat transfer receptacle in the vaporization chamber. The shroud is then flooded with nitrogen to provide an inert atmosphere around the apparatus. The vacuum control valve and vacuum by-pass valve are both opened to begin evacuation of the chamber systems. Chamber pressure is preferably reduced to about 0.67 Pa (5 micrometers mercury (Hg)), after which the by-pass valve is closed. The pressure is thereafter maintained at 0.67 Pa (5 micrometers Hg) by only the smaller vacuum manifold outlets. The heat transfer receptacle is then heated to a temperature of about 90°C to begin vaporization of the dimer. The pyrolysis chamber is preheated to about 690°C, and when the vaporized dimer passes through the pyrolysis chamber, substantially all of the dimer is pyrolyzed into monomer form and passes out through the post-pyrolysis chamber. The post-pyrolysis chamber, which is maintained at a temperature of about 25°C (about room temperature), captures any unpyrolyzed dimer which manages to escape the pyrolysis chamber. The AF4 monomer vapor is drawn into the deposition chamber, over the surface of the wafer, and outward through the distribution manifold wherein the monomer vapor deposits onto the cooled wafer. As stated previously, the walls of the deposition bell are heated to prevent deposition onto the chamber walls. Vaporization of the entire gram of dimer should result in about a 1 micrometer layer of Parylene AF4 on the wafer. However, the quartz crystal control monitors the coating thickness and controls vaporization of the dimer to achieve the desired 1 micrometer coating thickness. Any excess un-deposited monomer drawn through the manifold outlet is captured in the cold trap. After the desired thickness of coating is achieved, the throttle valve is closed to prevent any further deposition. While maintaining the vacuum, the temperature of the wafer is then brought up to room temperature by activating the platen heating elements. Once the wafer is at the desired room temperature, the vacuum valve is closed, the deposition bell removed, the electrostatic clamp deactivated, and the wafer removed from the platen.

It can therefore be seen that the instant invention provides a unique and effective paryiene deposition apparatus which is uniquely suited for the deposition of Parylene AF4. The heated and cooled platen provide an effective means for supporting a wafer for deposition and for controlling the temperature of the silicon wafer during processing. The electrostatic clamping device provides an effective means for clamping the wafer in intimate thermal contact with the platen without physically clamping the delicate wafer structure. The vaporization chamber is effective for the quick and efficient heating and cooling of the dimer to effectively control the dimer vaporization rate, and the associated throttle valve effective for the controlled release of vaporized dimer into the deposition system. The baffled post-pyrolysis chamber is effective for capturing dimer which exits the pyrolysis chamber. The dome-shaped deposition bell is unique and effective for minimizing deposition chamber volume while maximizing vapor flow over the surface of the platen . The vacuum manifold arrangement attached to the deposition bell enhances vapor flow directly over the surface of the platen and the vacuum by-pass arrangement facilitates quick and efficient pump-down of the chamber system in preparation for deposition. The quartz crystal rate controller also provides an effective means for accurately controlling deposition rate onto the wafers. For these reasons, the instant invention is believed to represent a significant advancement in the art.

## Claims

1. A parylene deposition apparatus comprising:
a vaporization chamber;
a pyrolysis chamber in fluid communication with said vaporization chamber;
a deposition chamber in fluid communication with said pyrolysis chamber;
a thermally conductive platen disposed in said deposition chamber for supporting an article to be coated;
a device for reducing the temperature of the thermally conductive platen such that the article disposed thereon may be cooled to a temperature below 15°C;
**characterised by** further comprising a heater for heating said thermally conductive platen to a temperature of from 100°C to 400°C prior to the removal of the article from the deposition chamber.

2. An apparatus as claimed in claim 1, further comprising:
the deposition chamber coupled to the pyrolysis chamber for receiving gaseous parylene monomer from said pyrolysis chamber;
vacuum means for creating sub-atmospheric conditions within said deposition chamber, said pyrolysis chamber and the vaporization chamber;
an atmospheric shroud enveloping said vaporization chamber, said pyrolysis chamber, and said deposition chamber; and
means for providing an inert gaseous atmosphere within said atmospheric shroud during vacuum evacuation of said deposition chamber, said pyrolysis chamber, and said vaporization chamber, and further during subsequent coating of a substrate disposed in said deposition chamber, whereby coating of said substrate is carried out in a substantially oxygen-free environment.

3. An apparatus as claimed in claim 1, further comprising:
a vacuum chamber system including the vaporization chamber, the pyrolysis chamber coupled to said vaporization chamber, and the deposition chamber coupled to said pyrolysis chamber for receiving gaseous parylene monomer from said pyrolysis chamber;
an oilless, dry vacuum pump having an inlet connected to said vacuum chamber system for creating sub-atmospheric conditions within said vacuum chamber system; and
trap means connected to an outlet of said vacuum pump for trapping excess unpolymerized monomer passing through the vacuum pump.

4. An apparatus as claimed in claim 1, further comprising:
a receptacle in the vaporization chamber for receiving a predetermined quantity of parylene dimer;
means for heating said parylene dimer to a predetermined temperature, whereby said parylene dimer is vaporized into a gaseous dimer;
temperature sensor means for measuring a temperature within said vaporization chamber;
the pyrolysis chamber coupled to the vaporization chamber for pyrolyzing said gaseous parylene dimer into gaseous parylene monomer;
the deposition chamber coupled to said pyrolysis chamber for receiving a substrate to be coated with said parylene monomer;
means for creating sub-atmospheric pressure conditions in said deposition chamber, said pyrolysis chamber and said vaporization chamber;
a quartz crystal disposed within said deposition chamber for receiving a coating of said parylene, said crystal producing an output signal corresponding to a thickness of coating received on said quartz crystal; and
controller means associated with said quartz crystal, said means for heating, and said temperature means wherein said controller means controls operation of said means for heating responsive to said output signal whereby the amount of parylene dimer vaporized, the associated deposition rate of said parylene monomer onto said substrate, and the end point thickness of the parylene coating is controlled.

5. An apparatus as claimed in claim 1, further comprising:
the deposition chamber coupled to the pyrolysis chamber for receiving gaseous parylene monomer;
filter means disposed in the flow path of said gaseous parylene monomer between said pyrolysis chamber and a substrate to be coated in said deposition chamber, said filter being operative for filtering out impurities in said parylene monomer prior to deposition onto said substrate; and
vacuum means for creating sub-atmospheric pressure conditions within said deposition chamber, said pyrolysis chamber and the vaporization chamber.

6. An apparatus as claimed in claim 1, further comprising:
a vacuum chamber system including the vaporization chamber, the pyrolysis chamber coupled to said vaporization chamber, and the deposition chamber coupled to said pyrolysis chamber for receiving gaseous parylene monomer;
means for selectively cooling the platen wherein heat is conducted out of said article through contact with said cooled platen; and
vacuum means for creating sub-atmospheric pressure conditions within said deposition chamber, said pyrolysis chamber and said vaporization chamber.

7. An apparatus as claimed in claim 1, further comprising:
a thermally conductive heat transfer receptacle disposed in the vaporization chamber;
a first heater capable of heating said transfer receptacle to a predetermined temperature;
a second heater capable of heating inner walls of said vaporization chamber; and
a device for heating and cooling the platen disposed within the deposition chamber.

8. An apparatus as claimed in claim 1, further comprising:
a vacuum chamber system including the vaporization chamber, the pyrolysis chamber coupled to said vaporization chamber, and the deposition chamber having an inlet end and an inlet opening in said inlet end, said inlet opening being coupled to said pyrolysis chamber for receiving a gaseous parylene monomer from said pyrolysis chamber, said deposition chamber having a tapered configuration including a smaller dimension end which defines said inlet end of said deposition chamber, and a larger dimension end which defines an outlet end of said deposition chamber;
a support assembly arranged adjacent the outlet end of the deposition chamber for supporting the article to be coated; and
vacuum means connected to an outlet opening at said outlet end of said deposition chamber for creating sub-atmospheric pressure conditions within said deposition chamber, said pyrolysis chamber and said vaporization chamber, and for drawing vapor flow from said inlet opening through said deposition chamber to said outlet opening, said tapered configuration of said deposition chamber minimising deposition chamber volume and maximising flow of monomer vapor over a surface of the article supported on said support assembly.

9. A parylene deposition chamber, comprising:
a body including an inlet opening having a diameter and at least one outlet opening having a diameter, the diameter of the inlet opening being greater than the diameter of the at least one outlet opening;
an inlet pipe in fluid communication with the inlet opening;
an outlet pipe in fluid communication with the at least one outlet opening;
a valve disposed at a junction between the inlet pipe and the outlet pipe;
a thermally conductive platen for supporting an article to be coated;
a device for reducing the temperature of the thermally conductive platen such that the article disposed thereon may be cooled to a temperature below 15°C; and
**characterised by** further comprising a heater for heating the thermally conductive platen to a temperature of from 100°C to 400°C prior to the removal of the article from the deposition chamber.

10. A vacuum chamber system, comprising:
a vaporization chamber having an outlet;
a pyrolysis chamber having an inlet and an outlet, the inlet of the pyrolysis chamber being in fluid communication with the outlet of the vaporization chamber; and
a parylene deposition chamber, comprising:
a body including an inlet opening having a diameter and at least one outlet opening having a diameter, the diameter of the inlet opening being greater than the diameter of the at least one outlet opening, the inlet opening being in fluid communication with the outlet of the pyrolysis chamber;
an inlet pipe in fluid communication with the inlet opening;
an outlet pipe in fluid communication with the outlet opening;
a valve disposed at the junction of the inlet pipe and the outlet pipe;
a thermally conductive platen disposed in the deposition chamber for supporting an article to be coated;
a device for reducing the temperature of the thermally conductive platen such that the article disposed thereon may be cooled to a temperature below 15°C; and
**characterised by** further comprising a heater for heating the thermally conductive platen to a temperature of from 100°C to 400°C prior to the removal of the article from the deposition chamber.

11. A method of forming a layer of parylene on a substrate in a deposition chamber, the method comprising the steps of:
vaporising parylene dimer;
pyrolyzing the parylene dimer to form parylene monomers;
cooling the substrate to a temperature below 15°C;
depositing parylene monomers on the substrate;
**characterised by** heating the substrate to a temperature of from 100°C to 400°C prior to its removal from the deposition chamber.

12. A method as claimed in claim 11, including:
cooling the substrate to a temperature below 0°C;
creating sub-atmospheric pressure conditions around said substrate;
depositing a predetermined thickness of said parylene polymer onto said substrate; and
heating said substrate prior to its removal from said sub-atmospheric conditions.

## Patentansprüche

1. Vorrichtung zur Abscheidung von Parylen, bestehend aus: einem Verdampfungsraum; einem Pyrolyseraum, der in fluidleitender Verbindung mit dem besagten Verdampfungsraum steht; einem Beschichtungsraum, der in fluidleitender Verbindung mit dem besagten Pyrolyseraum steht, einem thermisch leitenden Vorlagenträger, der in dem besagten Beschichtungsraum für die Aufnahme eines zu beschichtenden Gegenstandes angeordnet ist; einer Vorrichtung zur Verringerung der Temperatur des thermisch leitenden Vorlagenträgeres derart, daß der Gegenstand, der darauf anzuordnen ist, auf eine Temperatur unterhalb von 15 °C abgekühlt werden kann, **dadurch gekennzeichnet, daß** sie weiterhin eine Heizvorrichtung zum Aufheizen des besagten thermisch leitenden Vorlagenträgers auf eine Temperatur von 100 °C bis 400 °C vor der Entnahme des Gegenstandes aus dem Beschichtungsraum aufweist.

2. Vorrichtung gemäß Anspruch 1, die weiterhin umfaßt: daß der Beschichtungsraum zur Aufnahme der gasförmigen Parylen-Monomere aus dem Pyrolyseraum mit dem besagten Pyrolyseraum verbunden ist; Vakuummittel für das Erzeugen eines Unterdrucks innerhalb des besagten Beschichtungsraumes, des besagten Pyrolyseraumes und des Verdampfungsraumes; eine druckdichte Hülle, die den besagten Verdampfungsraum, den besagten Pyrolyseraum und den besagten Beschichtungsraum umgibt; und Mittel zur Erzeugung einer Inertgasatmosphäre innerhalb der besagten druckdichten Hülle während der Evakuierung des besagten Beschichtungsraumes, des besagten Pyrolyseraumes und des besagten Verdampfungsraumes und ferner während der nachfolgenden Beschichtung eines Substrates, das in dem besagten Beschichtungsraum angeordnet wird, wobei die Beschichtung des besagten Substrates in einer im wesentlichen sauerstofffreien Atmosphäre durchgeführt wird.

3. Vorrichtung gemäß Anspruch 1, die weiterhin umfaßt: ein Vakuumsystem einschließlich des Verdampfungsraumes, des mit dem besagten Verdampfungsraum verbundenen Pyrolyseraumes und des Beschichtungsraumes, der zur Aufnahme der gasförmigen Parylen-Monomere aus dem Pyrolyseraum mit dem besagten Pyrolyseraum verbunden ist; eine ölfreie trockene Vakuumpumpe mit einem Einlaß, der mit dem besagten Vakuumsystem zur Erzeugung eines Unterdrucks innerhalb des besagten Vakuumsystems verbunden ist; und einer Falle, die mit einem Auslaß der besagten Vakuumpumpe verbunden ist, um überschüssige unpolymerisierte Monomere aufzufangen, die durch die Vakuumpumpe hindurch gelangen.

4. Vorrichtung gemäß Anspruch 1, die weiterhin umfaßt: eine im Verdampfungsraum angeordnete Aufnahmewanne zur Aufnahme einer vorgegebenen Menge an Parylen-Dimer; Mittel für das Aufheizen des besagten Parylen-Dimers auf eine vorgegebene Temperatur, wodurch das besagte Parylen-Dimer als gasförmiges Dimer verdampft wird; Temperaturfühler zum Messen einer Temperatur innerhalb des besagten Verdampfungsraumes; daß der Pyrolyseraum mit dem Verdampfungsraum für das Pyrolysieren des besagten gasförmigen Parylen-Dimers in gasförmige Parylen-Monomere verbunden ist; daß der Beschichtungsraum mit dem besagten Pyrolyseraum zur Aufnahme eines mit den besagten Parylen-Monomeren zu beschichtenden Substrates verbunden ist; Mittel zur Erzeugung eines Unterdrucks in dem besagten Beschichtungsraum, in dem besagten Pyrolyseraum und in dem besagten Verdampfungsraum; einen innerhalb des besagten Beschichtungsraumes angeordneten Quarzkristall zur Aufnahme einer aus dem besagten Parylen bestehenden Schicht, wobei der besagte Kristall ein Ausgangssignal liefert, das der Stärke der auf dem besagtem Quarzkristall aufgedampften Schicht proportional ist; und mit dem besagten Quarzkristall, der besagten Aufheizvorrichtung und den besagten Mitteln zur Temperatureinstellung verbundene Steuermittel, wobei die besagten Steuermittel den Betrieb der besagten Aufheizvorrichtung in Abhängigkeit von dem besagten Ausgangssignal kontrollieren, wobei die Menge des verdampften Parylen-Dimers, die dazugehörige Abscheidungsrate des besagten Parylen-Monomers auf dem besagten Substrat und die endgültige Dicke der Parylenschicht erfaßt werden.

5. Vorrichtung gemäß Anspruch 1, die weiterhin umfaßt: daß der Beschichtungsraum mit dem Pyrolyseraum zur Aufnahme von gasförmigen Parylen-Monomeren verbunden ist; daß Filtermittel im Flußweg der besagten gasförmigen Parylen-Monomere zwischen dem besagtem Pyrolyseraum und einem im besagten Beschichtungsraum zu beschichtenden Substrat angeordnet sind, wobei der besagte Filter dazu dient, Verunreinigungen in den besagten Parylen-Monomeren vor deren Abscheidung auf dem besagten Substrat herauszufiltern; und Vakuummittel zur Erzeugung eines Unterdrucks innerhalb des besagten Beschichtungsraumes, des besagten Pyrolyseraumes und des Verdampfungsraumes.

6. Vorrichtung gemäß Anspruch 1, die weiterhin umfaßt: ein Vakuumsystem einschließlich des Verdampfungsraumes, des mit dem besagten Verdampfungsraum verbundenen Pyrolyseraumes und des Beschichtungsraumes, der mit dem besagten Pyrolyseraum zur Aufnahme der gasförmigen Parylen-Monomere verbunden ist; Mittel für die selektive Kühlung des Vorlagenträgers, wobei Wärme aus dem besagtem Gegenstand durch Kontakt mit dem besagtem gekühlten Vorlagenträger abgeführt wird; und Vakuummittel zur Erzeugung eines Unterdrucks innerhalb des besagten Beschichtungsraumes, des besagten Pyrolyseraumes und des besagten Verdampfungsraumes.

7. Vorrichtung gemäß Anspruch 1, die weiterhin umfaßt: eine thermisch leitende wärmeübertragungseinheit, die im Verdampfungsraum angeordnet ist, eine erste Heizung, die geeignet ist, die besagte Wärmeübertragungseinheit auf eine vorgegebene Temperatur aufzuheizen; eine zweite Heizung, die geeignet ist, die inneren Wände des besagten Verdampfungsraumes aufzuheizen, und eine Vorrichtung zum Aufheizen und Kühlen des innerhalb des Beschichtungsraumes angeordneten Vorlagenträgers.

8. Vorrichtung gemäß Anspruch 1, die weiterhin umfaßt: ein Vakuumsystem einschließlich des Verdampfungsraumes, des mit dem besagten Verdampfungsraum verbundenen Pyrolyseraumes, wobei der Beschichtungsraum ein Einlaßende mit einer Einlaßöffnung in dem besagten Einlaßende aufweist,
wobei die besagte Einlaßöffnung mit dem besagten Pyrolyseraum zur Aufnahme von gasförmigen Parylen-Monomeren aus dem besagten Pyrolyseraum verbunden ist, wobei der besagte Beschichtungsraum eine sich verjüngende Konfiguration mit einem Ende mit einer geringeren Abmessung aufweist, das das besagte Einlaßende des besagten Beschichtungsraumes bildet, und ein Ende mit einer größeren Abmessung, das ein Auslaßende des besagten Beschichtungsraumes bildet; eine Aufnahmevorrichtung, die an das Auslaßende des Beschichtungsraumes angrenzend angeordnet ist, um den zu beschichtenden Gegenstand zu haltern; und Vakuummittel, die mit einer Auslaßöffnung an dem besagten Auslaßende des besagten Beschichtungsraumes zur Erzeugung eines Unterdrucks innerhalb des besagten Beschichtungsraumes, des besagten Pyrolyseraumes und des besagten Verdampfungsraumes verbunden sind und die einen Gasstrom von der besagten Einlaßöffnung durch den besagten Beschichtungsraum zur besagten Auslaßöffnung hin zu erzeugen vermögen, wobei die besagte sich verjüngende Konfiguration des besagten Beschichtungsraumes das Volumen des Beschichtungsraumes minimiert und den Strom des Monomerdampfes über eine Oberfläche des auf der besagten Aufnahmevorrichtung gehalterten Gegenstandes maximiert.

9. Parylen-Beschichtungsraum, der folgendes umfaßt: einen Körper mit einer Einlaßöffnung mit einem Durchmesser und mit wenigstens einer Auslaßöffnung mit einem Durchmesser, wobei der Durchmesser der Einlaßöffnung größer ist als der Durchmesser der wenigstens einen Auslaßöffnung; ein Einlaßrohr in fluidleitender Verbindung mit der Einlaßöffnung; ein Auslaßrohr in fluidleitender Verbindung mit der wenigstens einen Auslaßöffnung; ein Ventil, das an einer Verzweigung zwischen dem Einlaßrohr und dem Auslaßrohr angeordnet ist; einen thermisch leitenden Vorlagenträger für die Aufnahme eines zu beschichtenden Gegenstandes; eine Vorrichtung zur Erniedrigung der Temperatur des thermisch leitenden Vorlagenträgers derart, daß der Gegenstand, der darauf angeordnet wird, auf eine Temperatur unterhalb von 15 °C abgekühlt werden kann, und **dadurch gekennzeichnet, daß** weiterhin eine Heizung für das Aufheizen des thermisch leitenden Vorlagenträgers auf eine Temperatur zwischen 100 °C und 400 °C vor der Entnahme des Gegenstands aus dem Beschichtungsraum vorgesehen ist.

10. Vakuumsystem, das folgendes umfaßt: einen Verdampfungsraum mit einem Auslaß; einen Pyrolyseraum mit einem Einlaß und einem Auslaß, wobei der Einlaß des Pyrolyseraumes in fluidleitender Verbindung mit dem Auslaß des Verdampfungsraumes steht; und einen Parylen-Beschichtungsraum, der folgendes umfaßt: einen Körper mit einer Einlaßöffnung mit einem Durchmesser und mit wenigstens einer Auslaßöffnung mit einem Durchmesser, wobei der Durchmesser der Einlaßöffnung größer ist als der Durchmesser der wenigstens einen Auslaßöffnung, wobei die Einlaßöffnung in fluidleitender Verbindung mit dem Auslaß des Pyrolyseraumes steht; ein Einlaßrohr in fluidleitender Verbindung mit der Einlaßöffnung; ein Auslaßrohr in fluidleitender Verbindung mit der wenigstens einen Auslaßöffnung; ein Ventil, das an einer Verzweigung zwischen dem Einlaßrohr und dem Auslaßrohr angeordnet ist; einen thermisch leitenden Vorlagenträger für die Aufnahme eines zu beschichtenden Gegenstands; eine Vorrichtung zur Erniedrigung der Temperatur des thermisch leitenden Vorlagenträgers derart, daß der Gegenstand, der darauf angeordnet wird, auf eine Temperatur unterhalb von 15 °C abgekühlt werden kann, und **dadurch gekennzeichnet, daß** weiterhin eine Heizung für das Aufheizen des thermisch leitenden Vorlagenträgers auf eine Temperatur zwischen 100 °C und 400 °C vor der Entnahme des Gegenstands aus dem Beschichtungsraum vorgesehen ist.

11. Verfahren zur Erzeugung einer Parylen-Beschichtung auf einem Substrat in einem Beschichtungsraum, das die folgenden Schritte umfaßt: das Verdampfen von Parylen-Dimer; die Pyrolyse des Parylen-Dimers zur Erzeugung von Parylen-Monomeren; das Abkühlen des Substrates auf eine Temperatur unterhalb von 15 °C; das Abscheiden von Parylen-Monomeren auf dem Substrat; **gekennzeichnet durch** das Aufheizen des Substrates auf eine Temperatur von 100 °C bis 400 °C vor seiner Entnahme aus dem Beschichtungsraum.

12. Verfahren gemäß Anspruch 11, das folgendes umfaßt: das Abkühlen des Substrates auf eine Temperatur unterhalb von 0 °C; die Erzeugung von Unterdruckbedingungen im Bereich des besagten Substrates; das Abscheiden einer Schichtvorgegebener Dicke des besagten Parylen-Polymers auf dem besagten Substrat; und das Aufheizen des besagten Substrates vor seiner Entnahme aus dem besagten Unterdruckbereich.

## Revendications

1. Appareil de dépôt de parylène, comprenant :
une chambre de vaporisation ;
une chambre de pyrolyse en communication par fluide avec ladite chambre de vaporisation ;
une chambre de dépôt en communication par fluide avec ladite chambre de pyrolyse ;
une platine thermoconductrice placée dans ladite chambre de dépôt pour porter un article à revêtir ;
un dispositif pour abaisser la température de la platine thermoconductrice, de telle sorte que l'article placé sur cette platine puisse être refroidi à une température inférieure à 15°C ;
**caractérisé en ce qu'**il comprend en outre un élément chauffant pour chauffer ladite platine thermoconductrice à une température comprise dans l'intervalle de 100°C à 400°C avant d'enlever l'article de la chambre de dépôt.

2. Appareil suivant la revendication 1, comprenant en outre :
la chambre de dépôt couplée à la chambre de pyrolyse pour recevoir un monomère parylène gazeux provenant de ladite chambre de pyrolyse ;
un moyen de mise sous vide pour créer des conditions sous-atmosphériques dans ladite chambre de dépôt, ladite chambre de pyrolyse et la chambre de vaporisation ;
une enveloppe atmosphérique englobant ladite chambre de vaporisation, ladite chambre de pyrolyse et ladite chambre de dépôt ; et
un moyen pour fournir une atmosphère gazeuse inerte dans ladite enveloppe atmosphérique au cours de la mise sous vide de ladite chambre de dépôt, de ladite chambre de pyrolyse et de ladite chambre de vaporisation, et en outre au cours du revêtement ultérieur d'un substrat placé dans ladite chambre de dépôt, le revêtement dudit substrat étant ainsi effectué dans un environnement pratiquement dépourvu d'oxygène.

3. Appareil suivant la revendication 1, comprenant en outre :
un système de chambre à vide comprenant la chambre de vaporisation, la chambre de pyrolyse couplée à ladite chambre de vaporisation, et la chambre de dépôt couplée à ladite chambre de pyrolyse pour recevoir un monomère parylène gazeux provenant de ladite chambre de pyrolyse ;
une pompe à vide sèche sans huile ayant un orifice d'admission connecté audit système de chambre à vide pour créer des conditions sous-atmosphériques dans ledit système de chambre à vide ; et
un moyen de piégeage connecté à un orifice de sortie de ladite pompe à vide pour piéger l'excès de monomère non polymérisé passant à travers la pompe à vide.

4. Appareil suivant la revendication 1, comprenant en outre :
un réceptacle dans la chambre de vaporisation pour recevoir une quantité prédéterminé de dimère de parylène ;
un moyen pour chauffer ledit dimère de parylène à une température prédéterminée, ledit dimère de parylène étant ainsi vaporisé en un dimère gazeux ;
un moyen de captage de température pour mesurer une température dans ladite chambre de vaporisation ;
la chambre de pyrolyse couplée à la chambre de vaporisation pour pyrolyser ledit dimère de parylène gazeux en un monomère parylène gazeux ;
la chambre de dépôt couplée à ladite chambre de pyrolyse pour recevoir un substrat à revêtir avec ledit monomère parylène ;
un moyen pour créer des conditions de pressien sous-atmlosphérique dans ladite chambre de dépôt, ladite chambre de pyrolyse et ladite chambre de vaporisation ;
un cristal de quartz placé dans ladite chambre de dépôt pour recevoir un revêtement dudit parylène, ledit cristal produisant un signal de sortie correspondant à une épaisseur de revêtement reçu sur ledit cristal de quartz ; et
un moyen de commande associé audit cristal de quartz, audit moyen de chauffage et audit moyen de captage de température, ledit moyen de commande commandant le fonctionnement dudit moyen de chauffage en réponse audit signal de sortie, ce qui permet de réguler la quantité de dimère de parylène vaporisée, la vitesse de dépôt associée dudit monomère parylène sur ledit substrat et l'épaisseur finale du revêtement de parylène.

5. Appareil suivant la revendication 1, comprenant en outre :
la chambre de dépôt couplée à la chambre de pyrolyse pour recevoir un monomère parylène gazeux ;
un moyen de filtration placé dans le trajet d'écoulement dudit monomère parylène gazeux entre ladite chambre de pyrolyse et un substrat à revêtir dans ladite chambre de dépôt, ledit filtre étant apte à séparer par filtration les impuretés dans ledit monomère parylène avant le dépôt sur ledit substrat ; et
un moyen de mise sous vide pour créer des conditions de pression sous-atmosphérique dans ladite chambre de dépôt, ladite chambre de pyrolyse et la chambre de vaporisation.

6. Appareil suivant la revendication 1, comprenant en outre :
un système de chambre à vide comprenant la chambre de vaporisation, la chambre de pyrolyse couplée à ladite chambre de vaporisation, et la chambre de dépôt couplée à ladite chambre de pyrolyse pour recevoir un monomère parylène gazeux ;
un moyen pour refroidir sélectivement la platine, la chaleur étant évacuée hors dudit article par contact avec ladite platine refroidie ; et
un moyen de mise sous vide pour créer des conditions de pression sous-atmosphérique dans ladite chambre de dépôt, ladite chambre de pyrolyse et ladite chambre de vaporisation.

7. Appareil suivant la revendication 1, comprenant en outre :
un réceptacle thermoconducteur de transfert thermique placé dans la chambre de vaporisation ;
un premier élément chauffant capable de chauffer ledit réceptacle de transfert à une température prédéterminée ;
un second élément chauffant capable de chauffer les parois intérieures de ladite chambre de vaporisation ; et
un dispositif pour chauffer et refroidir la platine placée dans la chambre de dépôt.

8. Appareil suivant la revendication 1, comprenant en outre :
un système de chambre à vide comprenant la chambre de vaporisation, la chambre de pyrolyse couplée à ladite chambre de vaporisation, et la chambre de dépôt ayant une extrémité d'admission et un orifice d'admission dans ladite extrémité d'admission, ledit orifice d'admission étant couplé à ladite chambre de pyrolyse pour recevoir un monomère parylène gazeux provenant de ladite chambre de pyrolyse, ladite chambre de dépôt ayant une configuration effilée comprenant une extrémité de dimension inférieure qui définit ladite extrémité d'admission de ladite chambre de dépôt, et une extrémité de dimension supérieure qui définit une extrémité de sortie de ladite chambre de dépôt ;
un assemblage de support placé en position adjacente à l'extrémité de sortie de la chambre de dépôt pour porter l'article à revêtir ; et
un moyen de mise sous vide connecté à un orifice de sortie à ladite extrémité de sortie de ladite chambre de dépôt pour créer des conditions de pression sous-atmosphérique dans ladite chambre de dépôt, ladite chambre de pyrolyse et ladite chambre de vaporisation, et pour aspirer un courant de vapeur par ledit orifice d'admission à travers ladite chambre de dépôt jusqu'audit orifice de sortie, ladite configuration effilée de ladite chambre de dépôt réduisant au minimum le volume de la chambre de dépôt et rendant maximal l'écoulement de vapeur de monomère sur une surface de l'article porté par ledit assemblage de support.

9. Chambre de dépôt de parylène, comprenant :
un corps comprenant un orifice d'admission ayant un diamètre et au moins un orifice de sortie ayant un diamètre, le diamètre de l'orifice d'admission étant supérieur au diamètre dudit au moins un orifice de sortie ;
un conduit d'admission en communication par fluide avec l'orifice d'admission ;
un conduit de sortie en communication par fluide avec ledit au moins un orifice de sortie ;
une vanne placée à une jonction entre le conduit d'admission et le conduit de sortie ;
une platine thermoconductrice pour porter un article à revêtir ;
un dispositif pour abaisser la température de la platine thermoconductrice, de telle sorte que l'article placé sur cette platine puisse être refroidi à une température inférieure à 15°C ; et
**caractérisée en ce qu'**elle comprend en outre un élément chauffant pour chauffer la platine thermoconductrice à une température comprise dans l'intervalle de 100°C à 400°C avant d'enlever l'article de la chambre de dépôt.

10. Système de chambre à vide, comprenant :
une chambre de vaporisation ayant un orifice de sortie ;
une chambre de pyrolyse ayant un orifice d'admission et un orifice de sortie, l'orifice d'admission de la chambre de pyrolyse étant en communication par fluide avec l'orifice de sortie de la chambre de vaporisation ; et
une chambre de dépôt de parylène, comprenant :
un corps comprenant un orifice d'admission ayant un diamètre et au moins un orifice de sortie ayant un diamètre, le diamètre de l'orifice d'admission étant supérieur au diamètre dudit au moins un orifice de sortie, l'orifice d'admission étant en communication par fluide avec l'orifice de sortie de la chambre de pyrolyse ;
un conduit d'admission en communication par fluide avec l'orifice d'admission ;
un conduit de sortie en communication par fluide avec l'orifice de sortie ;
une vanne placée à la jonction du conduit d'admission et du conduit de sortie ;
une platine thermoconductrice placée dans la chambre de dépôt pour porter un article à revêtir ;
un dispositif pour abaisser la température de la platine thermoconductrice, de telle sorte que l'article placé sur cette platine puisse être refroidi à une température inférieure à 15°C ; et
**caractérisé en ce qu'**il comprend en outre un élément chauffant pour chauffer la platine thermoconductrice à une température comprise dans l'intervalle de 100°C à 400°C avant d'enlever l'article de la chambre de dépôt.

11. Procédé pour former une couche de parylène sur un substrat dans une chambre de dépôt, procédé comprenant les étapes consistant :
à vaporiser un dimère de parylène ;
à pyrolyser le dimère de parylène pour former des monomères parylène ;
à refroidir le substrat à une température inférieure à 15°C ;
à déposer les monomères parylène sur le substrat ;
**caractérisé par** le chauffage du substrat à une température comprise dans l'intervalle de 100°C à 400°C avant de l'enlever de la chambre de dépôt.

12. Procédé suivant la revendication 11, comprenant les étapes consistant :
à refroidir le substrat à une température inférieure à 0°C ;
à créer des conditions de pression sous-atmosphérique autour dudit substrat ;
à déposer une épaisseur prédéterminée dudit polymère de parylène sur ledit substrat ; et
à chauffer ledit substrat avant de le soustraire aux conditions sous-atmosphériques.
